(19) Europäisches Patentamt
European Patent Office
Office européen des brevets

(11) EP 4 764 540 A1

(12) **EUROPEAN PATENT APPLICATION**
published in accordance with Art. 153(4) EPC

(43) Date of publication:
24.06.2026 Bulletin 2026/26

(21) Application number: 24880134.2

(22) Date of filing: 17.10.2024

(51) International Patent Classification (IPC):
G01R 31/392 (2019.01)      G01R 31/396 (2019.01)
G01R 31/385 (2019.01)      G01R 31/382 (2019.01)
G01R 19/10 (2006.01)       G01R 19/12 (2006.01)
G01R 19/00 (2006.01)       G01R 19/165 (2006.01)
G01R 31/367 (2019.01)      G06F 17/18 (2006.01)

(52) Cooperative Patent Classification (CPC):
G01R 19/00; G01R 19/10; G01R 19/12;
G01R 19/165; G01R 31/367; G01R 31/382;
G01R 31/385; G01R 31/392; G01R 31/396;
G06F 17/18

(86) International application number:
PCT/KR2024/015736

(87) International publication number:
WO 2025/084797 (24.04.2025 Gazette 2025/17)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 17.10.2023 KR 20230139022
16.10.2024 KR 20240141241

(71) Applicant: LG Energy Solution, Ltd.
Seoul 07335 (KR)

(72) Inventor: NAM, Hyun Woo
Daejeon 34122 (KR)

(74) Representative: Plasseraud IP
104 Rue de Richelieu
CS92104
75080 Paris Cedex 02 (FR)

(54) **BATTERY DIAGNOSIS APPARATUS, BATTERY DIAGNOSIS METHOD, AND BATTERY DIAGNOSIS SYSTEM**

(57) According to an aspect of the present invention, there is provided a battery management apparatus receives a plurality of resting voltages collected in a resting period after charging or discharging is completed from a plurality of battery cells, and is configured to calculate a plurality of voltage deviations based on a difference between a representative value of the plurality of resting voltages and each resting voltage, calculate a plurality of rates of change over time of the plurality of voltage deviations, and diagnose a state of at least one of the plurality of battery cells.

BATTERY DIAGNOSIS
APPARATUS
130

SENSOR
131

CONTROLLER
132

FIG.2

## Description

### TECHNICAL FIELD

CROSS-REFERENCE TO RELATED APPLICATION

This application claims the priority of Korean Patent Application No. 10-2023-0139022 filed on October 17, 2023 and Korean Patent Application No. 10-2024-0141241 filed on October 16, 2024, in the Korean Intellectual Property Office, the disclosure of which is incorporated herein by reference.

TECHNICAL FIELD

The present invention relates to a battery diagnosis apparatus, a battery diagnosis method, and a battery diagnosis system.

### BACKGROUND ART

Recently, research and development on secondary batteries are being actively conducted. Here, the secondary batteries are batteries that can be charged and discharged, and may be interpreted as including batteries that encompass both Ni/Cd batteries and Ni/MH batteries, and also more recently developed lithium-ion batteries. Among the secondary batteries, the lithium-ion batteries can have a higher energy density than those of Ni/Cd batteries, Ni/MH batteries, etc. and can be manufactured to be small and lightweight, and thus they can have high usability in terms of power sources for mobile devices. Recently, the range of uses for lithium-ion batteries has expanded to include power sources for electric vehicles, and they are attracting attention as a next-generation energy storage medium.

If a low-voltage defect occurs in a specific battery cell, a voltage of the low voltage cell may fluctuate significantly, unlike other battery cells, in a resting state after charging or discharging is completed. For example, after charging is completed, a self-discharge phenomenon may appear in the low voltage cell, which may cause a resting voltage to decrease to a greater extent than in the case of other battery cells. Such a low voltage phenomenon in a battery cell can lead to fire, and thus it may be necessary to reduce the time required for diagnosis.

DISCLOSURE

TECHNICAL PROBLEM

An aspect of the present invention provides a battery diagnosis apparatus, a battery diagnosis method, and a battery diagnosis system that can reduce the time required to diagnose a low voltage phenomenon in a battery cell.

The technical purpose of the embodiments disclosed in this document are not limited to the technical problems to be solved mentioned above, and other technical problems to be solved not mentioned will be clearly understood by those skilled in the art from the description below.

TECHNICAL SOLUTION

According to an aspect of the present invention, there is provided a battery management apparatus comprising a controller comprising one or more processors, and one or more computer-readable media storing computing instructions that, when executed on the one or more processors, cause the one more processors to perform: receiving a plurality of resting voltages for each of a plurality of battery cells, in a resting period after charging or discharging of the plurality of battery cells is completed, calculating a plurality of voltage deviations for each of the plurality of battery cells based on a difference between a representative value of the plurality of resting voltages and each of the plurality of resting voltages for each of the plurality of battery cells, calculating rates of change of the plurality of voltage deviations for each of the plurality of cells, and diagnosing a state of at least one of the plurality of battery cells based on a rate of change of the at least one battery cell.

According to another aspect, the computing instructions, when executed on the one or more processors, cause the one or more processors to perform: calculating an average and a standard deviation of the rates of change of the plurality of battery cells, and diagnosing whether or not a low voltage cell exists among the plurality of battery cells based on the average and the standard deviation.

According to another aspect, the computing instructions, when executed on the one or more processors, cause the one or more processors to perform: calculating a standard score for at least one of the plurality of battery cells based on the average and the standard deviation, and diagnosing the at least one battery as the low voltage cell when the standard score of the at least one battery is lower than a lower limit threshold.

According to another aspect, the computing instructions, when executed on the one or more processors, cause the one or more processors to perform: calculating a plurality of second deviations based on a difference between a representative value of the plurality of voltage deviations and each of the plurality of voltage deviations, and diagnosing whether or not a low voltage cell exists among the plurality of battery cells based on the rates of change of the plurality of voltage deviations for each of the plurality of cells, and the plurality of second deviations.

According to another aspect the computing instructions, when executed on the one or more processors, cause the one or more processors to perform: setting a normal range of the plurality of battery cells based on the plurality of second deviations and the plurality of rates of change over time, and diagnosing a battery cell having a second deviation or rate of change outside the normal range as the low voltage cell.

According to another aspect, the computing instructions, when executed on the one or more processors, cause the one or more processors to perform: calculating the plurality of voltage deviations for each of the plurality of battery cells based on a median of the plurality of resting voltages for each of the plurality of battery cells, and estimating slopes of each of the plurality of rates of change over time for each of the plurality of battery cells through a linear regression analysis.

According to another aspect, the computing instructions, when executed on the one or more processors, cause the one or more processors to perform: receiving the plurality of resting voltages, wherein the plurality of resting voltages are collected during a first time section after a buffering time has elapsed from an end time point of charging of the plurality of battery cells, and/or wherein the plurality of resting voltages are collected during a second time section from an end time point of discharging of the plurality of battery cells.

According to another aspect, the computing instructions, when executed on the one or more processors, cause the one or more processors to perform: calculating rates of change of the plurality of voltage deviations for each of the plurality of cells through a regression analysis.

According to another aspect, the computing instructions, when executed on the one or more processors, cause the one or more processors to perform: diagnosing states of each of the plurality of battery cells based on rates of change over time of the plurality of battery cell cells.

According to another aspect, the apparatus further comprises a sensor configured to collect the plurality of resting voltages for each of the plurality of battery cells, in the resting period after charging or discharging of the plurality of battery cells is completed.

According to another aspect, the apparatus comprises an interface that is configured to communicate with a sensor to receive the plurality of resting voltages for each of the plurality of battery cells, wherein the sensor is configured to collect the plurality of resting voltages for each of the plurality of battery cells, in the resting period after charging or discharging of the plurality of battery cells is completed.

According to another aspect, the computing instructions, when executed on the one or more processors, cause the one or more processors to perform: diagnosing at least one of the plurality of battery cells as a low-voltage cell and/or abnormal cell, and in response to the diagnosis, performing any of i) sending a warning alarm to a user device and/or display terminal regarding the at least one diagnosed cell ii) opening or cutting power to the at least one diagnosed cell, iii) grounding the at least one diagnosed cell, iv) limiting performance, output, and/or operating mode of an electrical device using the at least one diagnosed cell, and v) sending information regarding the at least one diagnosed cell to an external server.

According to another aspect, a battery management apparatus comprises: a controller comprising one or more processors, and one or more computer-readable media storing computing instructions that, when executed on the one or more processors, cause the one more processors to perform: receiving a plurality of resting voltages for each of a plurality of battery cells, in a resting period after charging or discharging of the plurality of battery cells is completed, calculating a plurality of voltage deviations for each of the plurality of battery cells based on a difference between a representative value of the plurality of resting voltages and each of the plurality of resting voltages for each of the plurality of battery cells, calculating a plurality of second deviations based on a difference between a representative value of the plurality of voltage deviations and each of the plurality of voltage deviations, and diagnosing whether or not a low voltage cell exists among the plurality of battery cells based on the plurality of second deviations.

According to another aspect, a battery management apparatus including a sensor configured to collect a plurality of resting voltages in a resting period after charging or discharging is completed from a plurality of battery cells and a controller configured to calculate a plurality of voltage deviations based on a difference between a representative value of the plurality of resting voltages and each resting voltage, calculate a plurality of rates of change over time of the plurality of voltage deviations through a regression analysis and diagnose a state of the plurality of battery cells based on the plurality of rates of change over time.

According to one aspect, the controller may be configured to calculate an average and a standard deviation of the plurality of rates of change over time and diagnose whether or not a low voltage cell exists among the plurality of battery cells based on the average and the standard deviation.

According to one aspect, the controller may be configured to calculate a standard score for each of the plurality of rates of change over time based on the average and the standard deviation and diagnose a battery cell having the standard score lower than a lower limit threshold among the plurality of battery cells as the low voltage cell.

According to one aspect, the controller may be configured to calculate a plurality of second deviations based on a difference between a representative value of the plurality of voltage deviations and each voltage deviation and diagnose whether or not a low voltage cell exists among the plurality of battery cells based on the plurality of rates of change over time and the plurality of second deviations.

According to one aspect, the controller may be configured to set a normal range of the plurality of battery cells based on the plurality of second deviations and the plurality of rates of change over time and diagnose a battery cell having the second deviation or rate of change over time outside the normal range as the low voltage cell.

According to one aspect, the controller may be configured to calculate the plurality of voltage deviations based on a median of the plurality of resting voltages and estimate a slope of each of the plurality of rates of change over time through a linear regression analysis.

According to one aspect, the sensor may be configured to collect the plurality of resting voltages during a first time section after a buffering time has elapsed from an end time point of charging of the plurality of battery cells and collect the plurality of resting voltages during a second time section from an end time point of discharging of the plurality of battery cells.

According to yet another aspect a battery management method is provided that is implemented via execution of computing instructions configured to run at one or more processors, the method comprising: receiving a plurality of resting voltages collected for each of a plurality of battery cells, in a resting period after charging or discharging of the plurality of battery cells is completed, calculating a plurality of voltage deviations for each of the plurality of battery cells based on a difference between a representative value of the plurality of resting voltages and each of the plurality of resting voltages for each of the plurality of battery cells, calculating rates of change of the plurality of voltage deviations for each of the plurality of cells, and diagnosing a state of at least one of the plurality of battery cells based on a rate of change of the at least one battery cell.

According to one aspect, diagnosing of the state of the at least one of the plurality of battery cells comprises calculating an average and a standard deviation of the rates of change of the plurality of battery cells, and diagnosing whether or not a low voltage cell exists among the plurality of battery cells based on the average and the standard deviation.

According to one aspect, diagnosing of the state of at least one of the plurality of battery cells comprises calculating a standard score for at least one of the plurality of battery cells based on the average and the standard deviation, and diagnosing the at least one battery cell as the low voltage cell when the standard score of the at least one battery cell is lower than a lower limit threshold.

According to one aspect, diagnosing of the state of at least one of the plurality of battery cells comprises calculating a plurality of second deviations based on a difference between a representative value of the plurality of voltage deviations and each of the plurality of voltage deviations, and diagnosing whether or not a low voltage cell exists among the plurality of battery cells based on the rates of change of the plurality of voltage deviations for each of the plurality of battery cells, and the plurality of second deviations.

According to one aspect, diagnosing of the state of at least one of the plurality of battery cells comprises setting a normal range of the plurality of battery cells based on the plurality of second deviations and the plurality of rates of change over time, and diagnosing a battery cell having a second deviation or rate of change outside the normal range as the low voltage cell.

According to one aspect, the calculating of the plurality of voltage deviations for each of the plurality of battery cells comprises calculating the plurality of voltage deviations based on a median of the plurality of resting voltages for each of the plurality of battery cells, and the calculating of rates of change of the plurality of voltage deviations comprises estimating slopes of each of the plurality of rates of change for each of the plurality of battery cells through a linear regression analysis.

According to one aspect, the receiving of the plurality of resting voltages comprises receiving a plurality of resting voltages collected during a first time section after a buffering time has elapsed from an end time point of charging of the plurality of battery cells, and/or receiving a plurality of resting voltages collected during a second time section from an end time point of discharging of the plurality of battery cells.

According to one aspect, a battery management method is provided that is implemented via execution of computing instructions configured to run at one or more processors, the method comprising: collecting a plurality of resting voltages for each of a plurality of battery cells, in a resting period after charging or discharging of the plurality of battery cells is completed; calculating a plurality of voltage deviations for each of the plurality of battery cells based on a difference between a representative value of the plurality of resting voltages and each of the plurality of resting voltages for each of the plurality of battery cells; calculating a plurality of second deviations based on a difference between a representative value of the plurality of voltage deviations and each of the plurality of voltage deviations, and diagnosing whether or not a target battery cell is a low voltage cell among the plurality of battery cells based on the plurality of second deviations.

According to another aspect of the present invention, there is provided a battery diagnosis method including collecting a plurality of resting voltages in a resting period after charging or discharging is completed from a plurality of battery cells, calculating a plurality of voltage deviations based on a difference between a representative value of the plurality of resting voltages and each resting voltage, calculating a plurality of rates of change over time of the plurality of voltage deviations through a regression analysis, and diagnosing a state of the plurality of battery cells based on the plurality of rates of change over time.

In one aspect, the diagnosing of the state of the plurality of battery cells may include calculating an average and a standard deviation of the plurality of rates of change over time and diagnosing whether or not a low voltage cell exists among the plurality of battery cells based on the average and the standard deviation.

In one aspect, the diagnosing of the state of the plurality of battery cells may include calculating a standard score for each of the plurality of rates of change over time based on the average and the standard deviation and diagnosing a battery cell having the standard score lower than a lower limit threshold among the plurality of battery cells as the low voltage cell.

In one aspect, the diagnosing of the state of the plurality of battery cells may include calculating a plurality of second deviations based on a difference between a representative value of the plurality of voltage deviations and each voltage deviation and diagnosing whether or not a low voltage cell exists among the plurality of battery cells based on the plurality of rates of change over time and the plurality of second deviations.

In one aspect, the diagnosing of the state of the plurality of battery cells may include setting a normal range of the plurality of battery cells based on the plurality of second deviations and the plurality of rates of change over time and diagnosing a battery cell having the second deviation or rate of change over time outside the normal range as the low voltage cell.

In one aspect, the calculating of the plurality of voltage deviations may include calculating the plurality of voltage deviations based on a median of the plurality of resting voltages and the calculating of the plurality of rates of change over time may include estimating a slope of each of the plurality of rates of change over time through a linear regression analysis.

In one aspect, the collecting of the plurality of resting voltages may include collecting the plurality of resting voltages during a first time section after a buffering time has elapsed from an end time point of charging of the plurality of battery cells and collecting the plurality of resting voltages during a second time section from an end time point of discharging of the plurality of battery cells.

According to another aspect, a battery management system is provided comprising the battery management apparatus according to embodiments herein, the battery management system comprising a charger/-discharger configured to charge or discharge a plurality of battery cells.

According to still another aspect of the present invention, there is provided a battery diagnosis system including a charger/discharger configured to charge or discharge a plurality of battery cells and a battery management apparatus configured to collect a plurality of resting voltages in a resting period after charging or discharging is completed from a plurality of battery cells, calculate a plurality of voltage deviations based on a difference between a representative value of the plurality of resting voltages and each resting voltage, calculate a plurality of rates of change over time of the plurality of voltage deviations through a regression analysis, and diagnose a state of the plurality of battery cells based on the plurality of rates of change over time.

ADVANTAGEOUS EFFECTS

According to the aspects of the present invention, the battery diagnosis apparatus, the battery diagnosis method, and the battery diagnosis system that can reduce the time required to diagnose a low-voltage phenomenon in the battery cell can be provided.

The technical effects according to the aspects of the present invention are not limited to the effects mentioned above, and other effects not mentioned will be clearly understood by those skilled in the art following the disclosure of this document.

**DESCRIPTION OF DRAWINGS**

FIG. 1 illustrates elements constituting a battery diagnosis system according to some embodiments;
FIG. 2 illustrates elements constituting a battery diagnosis apparatus according to some embodiments;
FIG. 3 illustrates how a voltage of a plurality of battery cells change in a resting section after charging or discharging is completed according to some embodiments;
FIG. 4 illustrates a plurality of resting voltages measured from a plurality of battery cells according to some embodiments;
FIG. 5 illustrates a plurality of voltage deviations of the plurality of resting voltages according to some embodiments;
FIG. 6 illustrates a process of diagnosing a state of the battery cells based on a plurality of rates of change over time according to some embodiments;
FIG. 7 illustrates a process of calculating a plurality of second deviations based on a difference between a representative value of a plurality of voltage deviations and each voltage deviation, according to some embodiments;
FIG. 8 illustrates a process of setting a normal range of the plurality of battery cells based on the plurality of second deviations and the plurality of rates of change over time according to some embodiments; and
FIG. 9 illustrates steps configuring a battery diagnosis method according to some embodiments..

MODE FOR INVENTION

Hereinafter, embodiments described in this document are described with reference to the accompanying drawings. However, this is not intended to limit the disclosure of this document to specific embodiments, and should be understood to include various modifications, equivalents, and/or alternatives to the embodiments described in this document.

Embodiments of this document and the terms used therein are not intended to limit the technical features described in this document to a specific embodiment, and should be understood to include various modifications, equivalents, or alternatives of the embodiment. In connection with the description of the drawings, similar reference numerals may be used for similar or related components. The singular form of a noun corresponding to an item may include one or more of the items, unless the relevant context clearly indicates otherwise.

In this document, each of phrases such as "A or B," "at least one of A and B," "at least one of A or B," "A, B, or C," "at least one of A, B, and C," and" at least one of A, B, or C" may include any one of the items listed together in that phrase of the phrases, or any possible combination thereof. Terms such as "first", "second", "firstly", "secondly", "A", "B", "(a)", or "(b)" may be used simply to distinguish such a component from other such components and, unless specifically stated to the contrary, do not limit such elements in any other respect (e.g., importance or order).

In this document, when a certain (e.g., first) component is referred to as "being connected", "being coupled," or "being joined" to another (e.g. second) component, with or without the terms "functionally" or "communicatively", or is referred to as "coupled" or "connected", it means that the certain component may be connected to the other component directly (e.g., in a wired manner or wirelessly) or indirectly (e.g., through a third component).

Methods according to various embodiments disclosed in this document may be provided by being included in a computer program product. The computer program product is a commodity and may be traded between sellers and buyers. The computer program product may be distributed in the form of a computer-readable storage medium (e.g., compact disc read only memory (CD-ROM)) or distributed through an application store, distributed online (e.g., may be downloaded or uploaded) directly between two user devices. In the case of online distribution, at least a portion of the computer program product may be at least temporarily stored or temporarily created in the computer-readable storage medium, such as a memory of a manufacturer's server, application store's server, or relay server. According to aspects herein, one or computer readable media may store computing instructions that, when executed on one or more processors, cause the processors to perform aspects of the embodiments of battery cell management and/or diagnosis described herein.

According to the embodiments disclosed in this document, each component (e.g., module, computing instructions, or program) of the components described above may include a single or plurality of entities, and some of the plurality of entities may be separately disposed in other components. According to embodiments disclosed in this document, one or more components of the corresponding components described above or operations thereof may be omitted, or one or more other components or operations thereof may be added. Alternatively or additionally, a plurality of components (e.g., module, computing instructions or program) may be integrated into a single component. In this case, the component in which the plurality of components are integrated may perform one or more functions of each component of the plurality of components in the same or similar manner as those performed by the corresponding component of the plurality of components prior to the integration. According to embodiments disclosed in this document, the operations performed by the module, computing instructions, program, or other components may be executed sequentially, in parallel, iteratively, or heuristically, or one or more operations of the operations may be executed in a different order or omitted, or one or more other operations may be added.

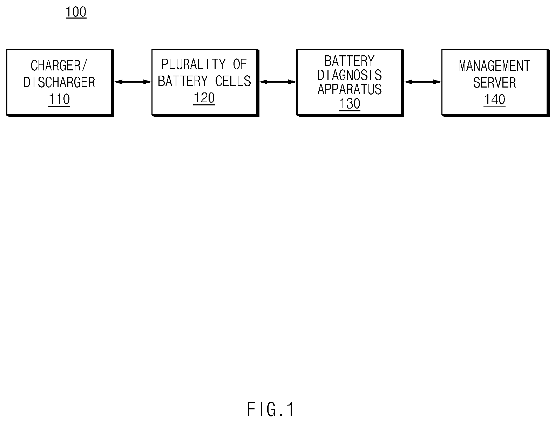

FIG. 1 illustrates elements constituting a battery diagnosis system according to some embodiments.

Referring to FIG. 1, a battery diagnosis system 100 may include a charger/discharger 110, a plurality of battery cells 120, a battery diagnosis apparatus 130, and a management server 140. However, it is not limited thereto, and some components may be omitted from the battery diagnosis system 100, or other general-purpose components may be further included in the battery diagnosis system 100.

The battery diagnosis system 100 may refer to a system for diagnosing the plurality of battery cells 120. The plurality of battery cells 120 may be charged or discharged by the charger/discharger 110, and the battery diagnosis apparatus 130 may diagnose the plurality of battery cells 120 by analyzing data regarding charging and discharging of the plurality of battery cells 120.

The charger/discharger 110 can charge or discharge the plurality of battery cells 120. According to an embodiment, the charger/discharger 110 may include a power supply device configured to apply a test voltage or test current to the plurality of battery cells 120. The test voltage/current may include a plurality of charge/discharge cycle voltages/currents. According to an embodiment the charger/discharge device 110 may include a mobility device such as an electric vehicle (HEV), a hybrid electric vehicle (HEV), or an electric bike, which is equipped with a plurality of battery cells 120.

The plurality of battery cells 120 may constitute a battery to be diagnosed. According to an embodiment, the battery to be diagnosed may include a plurality of battery modules, and the plurality of battery modules may include the plurality of battery cells 120. According to an embodiment, the plurality of battery cells 120 may constitute a cylindrical battery pack, and the cylindrical battery pack may be used in a battery swapping system (BSS).

The battery diagnosis apparatus 130 may perform operations for diagnosing the plurality of battery cells 120. The battery diagnosis apparatus 130 may measure battery data from the plurality of battery cells 120 and diagnose the plurality of battery cells 120 based on the battery data. According to an embodiment, the battery diagnosis apparatus 130 may diagnose whether or not a low voltage abnormality occurs in at least one cell among the plurality of battery cells 120. According to an embodiment, the battery diagnosis apparatus 130 may be a battery management system (BMS) device configured to integrated with the plurality of battery cells 120.

The management server 140 may manage a diagnosis process and a diagnosis result of the battery diagnosis apparatus 130. The management server 140 may exchange data with the battery diagnosis apparatus 130 through in a wired/wireless communication method. When battery data is measured or a defect is diagnosed from the plurality of battery cells 120, the results thereof may be transmitted to the management server 140 and recorded in a database. According to an embodiment the management server 140 may receive data for battery diagnosis and may perform operations for diagnosing the battery 120 to be diagnosed instead of the battery diagnosis apparatus 130. On the other hand, the battery diagnosis apparatus 130 may perform diagnostic operations by executing battery management software comprising computing instructions, and the management server 140 may provide installation information and update information of the battery management software to the battery diagnosis apparatus 130.

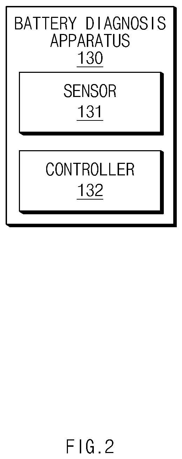

FIG. 2 illustrates elements constituting the battery diagnosis apparatus according to some embodiments.

Referring to FIG. 2, the battery diagnosis apparatus 130 may include a sensor 131 and a controller 132. However, it is not limited thereto, and some components may be omitted from the battery diagnosis apparatus 130, or other general-purpose components may be further included in the battery diagnosis apparatus 130. According to one embodiment, the battery diagnosis apparatus 130 includes one or even a plurality of sensors, such as one or more sensors that are on-board the apparatus 130. According to another embodiment, the battery diagnosis apparatus is capable of communicating with one or more off-board or remote sensors, such as for example via an interface comprising a communication circuit, module, and/or chip, or the like, that is capable of receiving information from the one or more remote sensors. For example, the battery diagnosis apparatus may be capable of communicating with one or more remote sensors in a case where the battery diagnosis apparatus is located in a remote server, or is a part of a battery charger or vehicle controller, that is separate from the one or more sensors.

According to an embodiment, in the battery diagnosis apparatus 130, the sensor 131 and the controller 132 may be electrically connected to each other through an inter-device communication method. The inter-device communication method may include a bus, general purpose input and output (GPIO), serial peripheral interface (SPI), mobile industry processor interface (MIPI), etc.

The sensor 131 may be configured to generate various battery measurement values from the battery 120 to be diagnosed. To this end, the sensor 131 may include measuring means such as a voltmeter, ammeter, or thermometer. According to certain embodiments, the sensor 131 may be a single device, or the sensor 131 may comprise a plurality of separate devices that are capable of generating various battery measurement values, and that can be provided in communication with the controller 132.

The controller 132 may have a structure for executing instructions that implement the operations of the battery diagnosis apparatus 130. The controller 132 may be implemented as an array of multiple logic gates or a general-purpose microprocessor for processing various logic and arithmetic operations, and may be composed of a single processor or a plurality of processors. For example, the controller 132 may be implemented in the form of at least one of a microprocessor, CPU, GPU, and AP.

The controller 132 may operate with computer readable storage media such as a memory configured to store various data, computing instructions, mobile applications, computer programs, etc. The memory may be configured separately or integrally with the controller 132. The controller 132 may process various logic and arithmetic operations by executing instructions stored in the computer readable storage media, such as the memory. For example, the memory may be implemented as a non-volatile device such as ROM, PROM, EPROM, EEPROM, flash memory, PRAM, MRAM, RRAM, FRAM, etc., or as a volatile device such as DRAM, SRAM, SDRAM, PRAM, HDD, etc., and may be implemented in the form of SSD, SD, Micro-SD, etc., or a combination thereof. According to one embodiment, controller 132 comprises an interface capable of communicating with one or more sensors, such as for example a communication circuit, module, and/or chip, or the like, that is capable of receiving information from one or more sensors, such as one or more remote sensors. According to one embodiment, the controller 132 may comprise one or more processors, and one or more computer-readable media storing computing instructions that, when executed on the one or more processors, cause the one or more processors to perform aspects of the disclosure described herein, such as battery management and diagnosis.

The sensor 131 may be configured to collect a plurality of resting voltages in a resting period after charging or discharging is completed from the plurality of battery cells 120. In the resting period after charging or discharging is completed, the plurality of battery cells 120 may show a specific voltage pattern, and a resting voltage related to this may be collected from each battery cell. For example, in the resting state after charging is completed, a pattern may appear in which the voltage of a battery cell steadily decreases, and in the resting state after discharging is completed, a pattern may appear in which the voltage of the battery cell steadily increases. According to an embodiment, the resting voltage collected from each battery cell may be a voltage curve composed of measurement values over time. For example, the sensor 131 may collect a plurality of resting voltages for each of the plurality of cells, to provide voltage curves composed of measurement values over time for each of the plurality of cells. According to certain embodiments, the sensor 131 may be a single device that is capable of collecting the plurality of resting voltages for each of the plurality of cells. According to certain other embodiments, the sensor 131 may comprise a plurality of separate devices that are capable of collecting the plurality of resting voltages for each of the plurality of cells.

The controller 132 may be configured to calculate a plurality of voltage deviations based on a difference between a representative value of the plurality of resting voltages and each resting voltage. For example, when n resting voltage curves for n battery cells are collected, a representative value curve composed of a representative value such as an average value or a median of the n resting voltage curves at each measurement time point may be calculated, and n voltage deviation curves may be generated based on a difference between the n resting voltage curves and the representative value curve. According to one embodiment, the controller 132 is configured to calculate a plurality of voltage deviations for each of the plurality of battery cells based on a difference between a representative value of the plurality of resting voltages (e.g., an average or median of the resting voltages of the plurality of battery cells at each time point) and each of the plurality of resting voltages for each of the plurality of battery cells.

According to one embodiment, the controller 132 may be configured to calculate rates of change of the plurality of voltage deviations for each of the plurality of cells. For example, the controller 132 may be configured to calculate a plurality of rates of change over time of the plurality of voltage deviations through a regression analysis. When n voltage deviation curves are generated, the rate of change over time of each voltage deviation curve may be calculated. The rate of change over time may mean a slope in a time-voltage graph. The rate of change over time of each voltage deviation curve may be estimated through the regression analysis, or other suitable fitting technique.

The controller 132 may be configured to diagnose the state of at least one of the plurality of battery cells 120, and even all of the plurality of battery cells, based on a rate of change of the voltage deviation determined for the at least one battery cell, or even based on a plurality of rates of change of the plurality of voltage deviations for each of the plurality of cells. For example, in the case of a normal battery cell, the rate of change over time of the voltage deviation curve may remain constant, while in the case of a low voltage battery cell, the rate of change over time of the voltage deviation curve may continuously decrease or increase. Based on this pattern, the battery cell corresponding to a rate of change over time that increases or decreases among the plurality of rates of change over time may be diagnosed as a defective battery cell.

According to an embodiment, the controller 132 may be configured to calculate the average and standard deviation of the plurality of rates of change of the plurality of battery cells(over time), and diagnose whether or not the low voltage cell exists among the plurality of battery cells 120 based on the average and the standard deviation. In order to determine whether or not the rate of change over time of the voltage deviation curve continuously decreases or increases, a statistical technique based on the average and standard deviation of the plurality of rates of change over time may be used.

According to an embodiment, the controller 132 may be configured to calculate a standard score of each of the plurality of rates of change over time based on the average and the standard deviation, and diagnose the battery cell having a standard score lower than the lower limit threshold among the plurality of battery cells 120 as the low voltage cell. According to one embodiment, the controller may be configured to calculate a standard score for at least one of, and even all, of the plurality of battery cells, based on the average and standard deviation. As in Equation 1 below, the standard score may mean a value obtained by dividing a value, which is obtained by subtracting the average value from each rate of change over time value, by the standard deviation. The standard score $Score_i$ may be compared to the lower limit threshold, and according to an embodiment, the lower limit threshold may be -3, which may mean $-3\sigma$ corresponding to the bottom 0.3%.

[Equation 1]

$$Score_i = \frac{Slope_i - Mean(Slopes)}{Stdev(Slopes)}$$

According to an embodiment, the controller 132 may be configured to calculate a plurality of second deviations based on a difference between the representative value of the plurality of voltage deviations and each of the plurality of voltage deviations, and diagnose whether or not the low voltage cell exists among the plurality of battery cells 120 based on the plurality of rates of change (over time) of the plurality of voltage deviations for each of the plurality of cells and/or and the plurality of second deviations. The plurality of second deviations may refer to deviation values of the plurality of voltage deviations (e.g. deviations at each time point). For example, the plurality of second deviations may be calculated based on the representative value such as an average value or median of the plurality of voltage deviations (e.g. an average or median of the voltage deviations of the plurality of battery cells at each time point). Each second deviation may indicate how far the voltage deviation of the corresponding battery cell is from the voltage deviations of other battery cells. When considering the plurality of second deviations together with the plurality of rates of change over time, an outlier battery cell may be determined.

According to an embodiment, the controller 132 may be configured to set a normal range of the plurality of battery cells 120 based on the plurality of second deviations and the plurality of rates of change over time, and diagnose the battery cell having the second deviation or rate of change over time outside the normal range as the low voltage cell. According to an embodiment, a lower limit value of the second deviation and a lower limit value of the rate of change over time may be set, the normal range of the plurality of battery cells 120 may be set based on these lower limits, and the battery cell outside the normal range may be diagnosed as a defective cell. The lower limit value of the second deviation and the lower limit value of the rate of change over time may be set to appropriate statistical values. For example, at least one value from $-1\sigma$ to $-3\sigma$ may be used as the lower limit values.

According to an embodiment, the controller 132 may be configured to calculate the plurality of voltage deviations based on the median of the plurality of resting voltages (e.g. at each time point) and estimate the slope of each of the plurality of rates of change over time through a linear regression analysis. The representative value used in calculating the plurality of voltage deviations may be the median of the plurality of resting voltages (e.g. the median of the plurality of resting voltages at each time point), and the regression analysis technique used to estimate the slope of each rate of change over time may be the linear regression analysis.

According to one embodiment, the controller 132 may be configured to calculate a plurality of second deviations based on a difference between a representative value of the plurality of voltage deviations and each of the plurality of voltage deviations, and diagnose whether or not at least one battery cell is a low voltage cell among the plurality of battery cells based on a second deviation of the at least one battery cell. According to another embodiment, the controller 132 may be capable of diagnosing each of the plurality of battery cells based on the plurality of second deviations of each of the plurality of battery cells.

According to an embodiment, the sensor 131 may be configured to collect the plurality of resting voltages during a first time section after a buffering time has elapsed from an end time point of charging of the plurality of battery cells 120, and/or to collect a plurality of resting voltages during a second time section from an end time point of discharging of the plurality of battery cells 120. The section during which the plurality of resting voltages are collected may vary depending on whether it is resting after charging or resting after discharging. In the case of the resting after discharging, the plurality of resting voltages may be collected immediately after discharging ends, while in the case of the resting after charging, a plurality of resting voltages may be collected after a certain buffering time has elapsed. This may be because a voltage behavior in the resting state may appear differently in the case of charging and discharging.

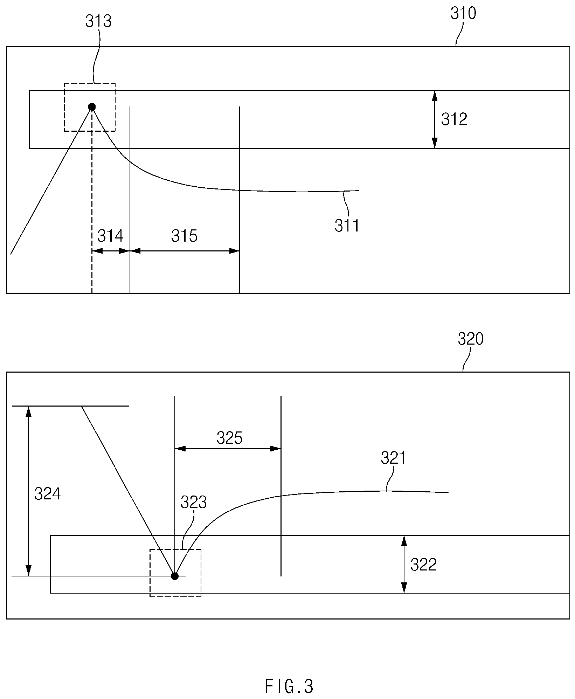

FIG. 3 illustrates how the voltage of the plurality of battery cells changes in the resting section after charging or discharging is completed according to some embodiments.

Referring to FIG. 3, graphs 310 and 320 showing how the voltage of the plurality of battery cells fluctuate in the resting section after charging or discharging is completed are illustrated.

The graph 310 may represent the resting section after charging is completed. A SOC 311 may continue to rise due to charging, and when a charging end SOC section 312 is entered, a charging voltage may no longer be provided at a charging completion time point 313. When a buffering time 314 elapses immediately after the charging completion time point 313, the SOC 311 may gradually decrease, and the plurality of resting voltages may be collected during a first time section 315. According to an embodiment, the buffering time 314 may be 5 minutes, the first time section 315 may be 10 minutes, and specific values may vary depending on need.

The graph 320 may represent the resting section after completion of discharging. A SOC 321 may continuously decrease due to discharging, and when a discharging end SOC section 322 is entered, the discharging may end at a discharging completion time point 323. A discharged amount up to the discharging completion time point 323 may be expressed as depth of discharge (DOD) (324). The plurality of resting voltages may be collected during a second time section 325 immediately after the discharging completion time point 323. According to the embodiment, the second time section 325 may be 10 minutes, and specific values may vary as needed.

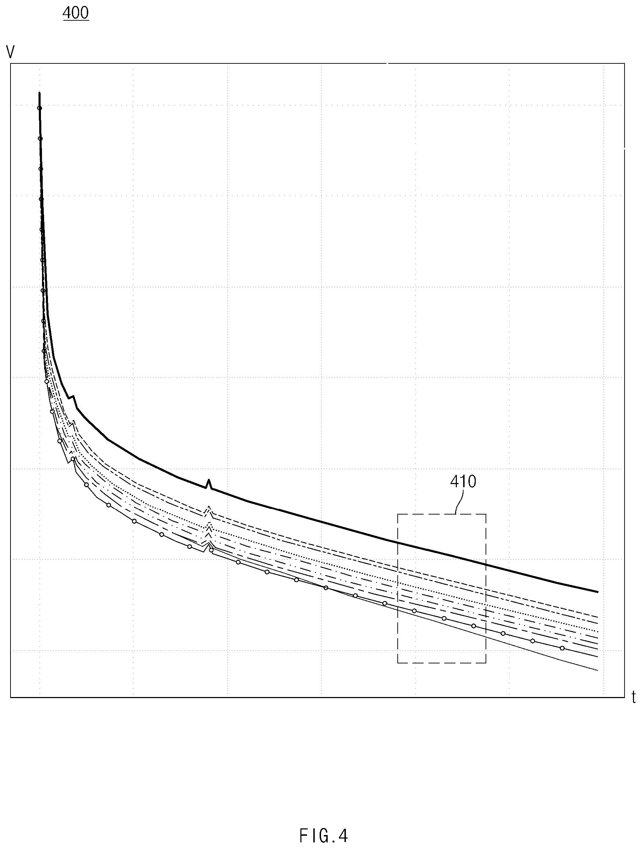

FIG. 4 illustrates the plurality of resting voltages measured from a plurality of battery cells according to some embodiments.

Referring to FIG. 4, a graph 400 showing a plurality of resting voltages 410 measured from the plurality of battery cells 120 is illustrated. The graph 400 illustrates n resting voltage curves for n battery cells. The graph 400 may represent a resting state after completion of charging.

As in the first time section 315 of the graph 310 of FIG. 3 described above, the plurality of resting voltages 410 of the graph 400 may continuously decrease after charging is terminated. In this case, it may be determined whether or there is the low voltage cell among the plurality of battery cells 120 based on the rate of change over time (slope) of each of the plurality of resting voltages 410.

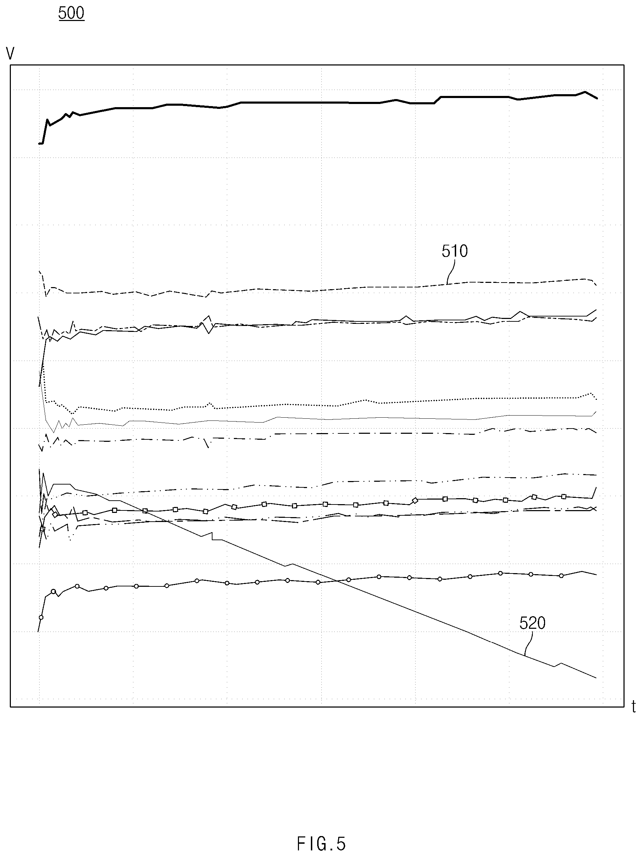

FIG. 5 illustrates the plurality of voltage deviations of the plurality of resting voltages according to some embodiments.

Referring to FIG. 5, a graph 500 showing the plurality of voltage deviations of the plurality of resting voltages is illustrated. The graph 500 may illustrate the plurality of voltage deviations of the plurality of resting voltages 410 illustrated in the graph 400 of FIG. 4.

The plurality of voltage deviations in the graph 500 may be calculated based on the representative value of the plurality of resting voltages 410 (e.g. a mean or median value of the resting voltage for each of the plurality of cells at each time point). According to an embodiment, the difference between each of the plurality of resting voltages 410 and the median of the plurality of resting voltages 410 may be calculated as a voltage deviation. In the case of the normal battery cell, the voltage deviation over time may be maintained constant, as shown in a first voltage deviation curve 510. On the other hand, in the case of the low voltage battery cell, the voltage deviation over time may continuously decrease or increase, as shown in a second voltage deviation curve 520. A reference value of the slope for diagnosing it as a low voltage defect may be calculated based on a standard score using the average and standard deviation.

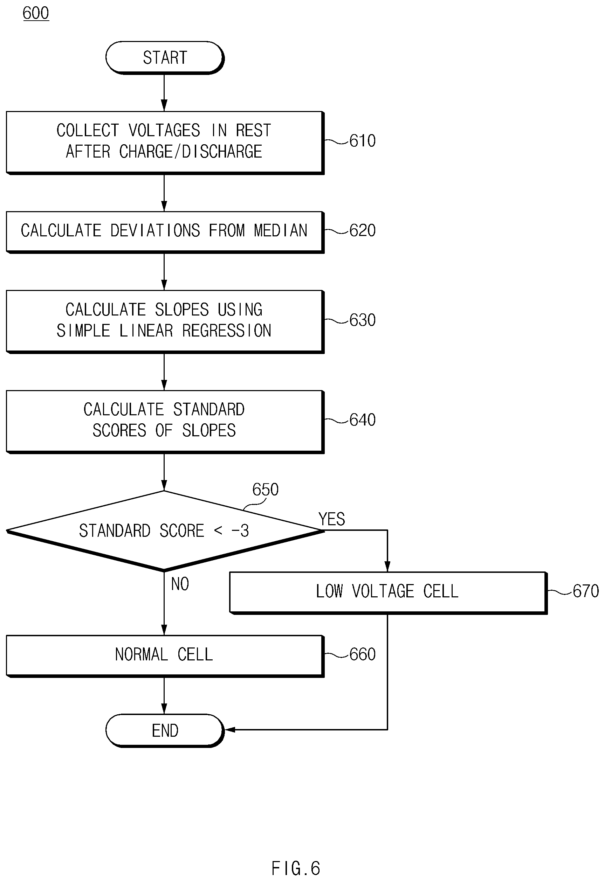

FIG. 6 illustrates a process of diagnosing the state of the battery cell based on the plurality of rates of change over time according to some embodiments.

Referring to FIG. 6, an algorithm 600 representing a process of diagnosing the state of the battery cell based on the plurality of rates of change over time is illustrated.

In step 610, resting voltages may be collected in the resting state after completion of charging or discharging. In step 620, voltage deviations of the resting voltages may be calculated based on the median. In step 630, slope values of the voltage deviations may be calculated using the linear regression. In step 640, the standard score of the slope values may be calculated using the average and standard deviation.

In step 650, the standard score of each slope (rate of change over time) may be compared to a threshold. The threshold for low voltage diagnosis may be -3, which may correspond to -3σ, meaning the bottom 0.3%. Meanwhile, the threshold may also be changed to a different value according to the change in diagnostic requirement values. If the standard score is not less than -3 (No), the battery cell may be diagnosed as the normal cell in step 660. If the standard score is less than -3 (Yes), the corresponding battery cell may be diagnosed as the low voltage cell in step 670.

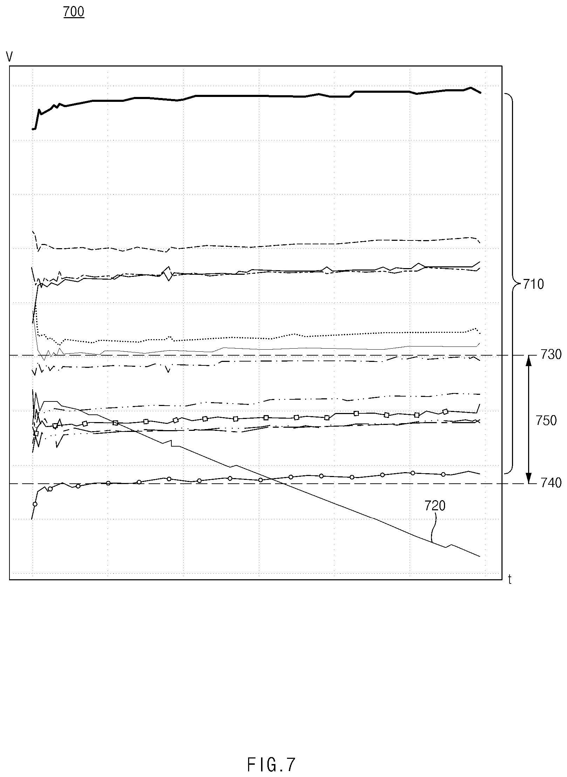

FIG. 7 illustrates a process of calculating the plurality of second deviations based on a difference between the representative value of the plurality of voltage deviations (e.g. an average or median of the voltage deviations for each cell at each time point) and each voltage deviation, according to some embodiments.

Referring to FIG. 7, a graph 700 showing the process of calculating the plurality of second deviations based on the difference between the representative value of the plurality of voltage deviations and each voltage deviation is illustrated.

The graph 700 may be the same as graph 500 in FIG. 5. The graph 700 illustrates a plurality of voltage deviations 710 of the plurality of battery cells 120. A first voltage deviation 720 corresponding to a first battery cell among the plurality of battery cells 120 may continuously decrease due to self-discharge after completion of charging.

A representative value 730 of the plurality of voltage deviations 710 may be calculated. The representative value 730 may be an average value, a median, etc. of the plurality of voltage deviations 710 (e.g. at each time point). In addition, a representative value 740 of the first voltage deviation 720 may be calculated. The representative value 740 may be an average value, a median, etc. of the measurement values of the first voltage deviation 720 (e.g. at each time point).

A second deviation 750 between the representative value 730 and the representative value 740 may be a second deviation calculated with respect to the first voltage deviation 720. Second deviations may also be calculated for voltage deviations other than the first voltage deviation 720 among the plurality of voltage deviations 710. The plurality of second deviations calculated in this way may be one characteristic of the plurality of battery cells 120.

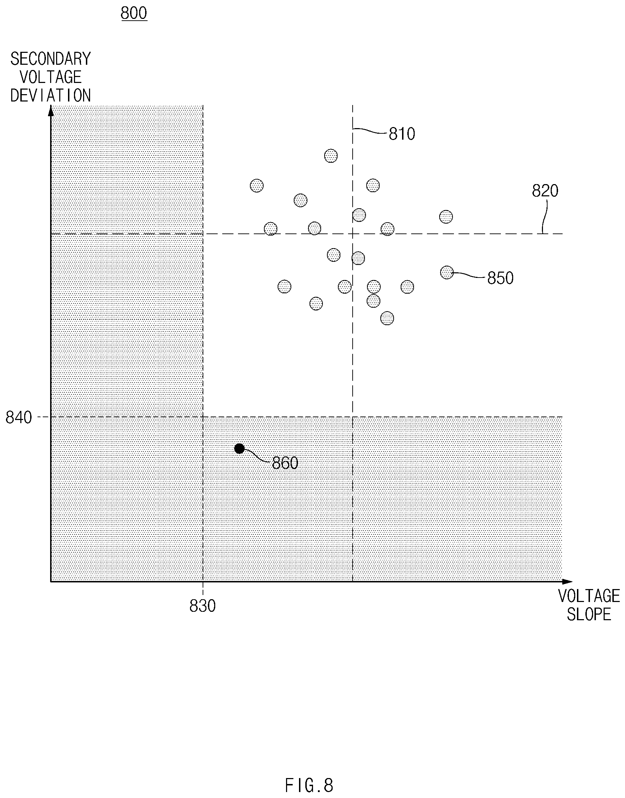

FIG. 8 illustrates a process of setting a normal range of the plurality of battery cells based on the plurality of second deviations and the plurality of rates of change over time according to some embodiments.

Referring to FIG. 8, a graph 800 showing a process of setting the normal range of the plurality of battery cells based on the plurality of second deviations and a plurality of rates of change over time is illustrated.

The graph 800 illustrates a normal range and lower limit values of the normal range regarding the rate of change over time (slope) on the horizontal axis and the second deviation on the vertical axis. The rate of change over time (slope) of the graph 800 may be calculated as in the graph 500 of FIG. 5, and the second deviation of the graph 800 may be calculated like the second deviation 750 of FIG. 7. Each of the plurality of battery cells 120 may be represented as one dot having a slope value and a second deviation value.

The graph 800 illustrates a representative value 810 of the slope values of the plurality of battery cells 120 and a representative value 820 of the second deviation values of the plurality of battery cells 120. The representative value 810 and 820 may be an average value or a median. A slope lower limit value 830 may be set based on the representative value 810 and standard deviation of the slope values, and a second deviation lower limit value 840 may be set based on the representative value 820 and standard deviation of the second deviation values. According to an embodiment, the slope lower limit value 830 and/or the second deviation lower limit value 840 may be set to any one of -1σ to -3σ, or any other appropriate value.

In the graph 800, the normal range of the plurality of battery cells 120 may be set by the slope lower limit value 830 and the second deviation lower limit value 840. For example, among the plurality of battery cells 120, the first battery cell 850 that falls within the normal range may be diagnosed as the normal battery cell, and the second battery cell 860 outside the normal range may be diagnosed as the low voltage battery cell.

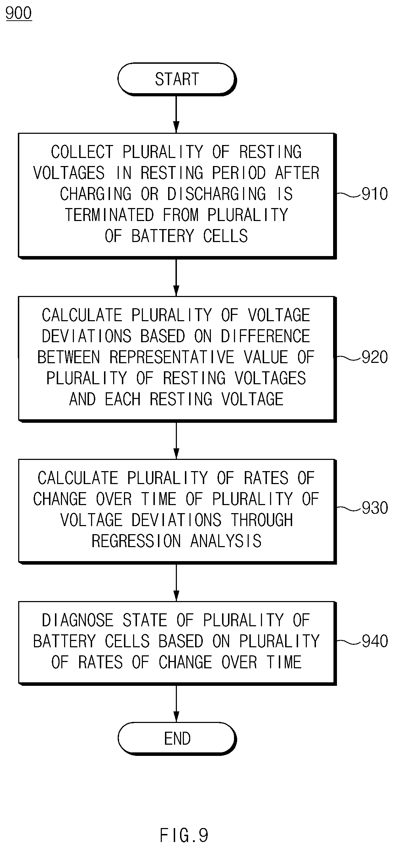

FIG. 9 illustrates steps configuring the battery diagnosis method according to some embodiments.

Referring to FIG. 9, a battery diagnosis method 900 may include steps 910 to 940. However, it is not limited thereto, some steps may be omitted or other general-purpose steps may be added, and the steps of the battery diagnosis method 900 may be executed in a different order from the illustrated order.

The battery diagnosis method 900 may be composed of steps processed in time series by the battery diagnosis apparatus 130. Therefore, even if the content is omitted below, the content described above with respect to the battery diagnosis apparatus 130 may be equally applied to the battery diagnosis method 900.

Steps 910 to 940 of the battery diagnosis method 900 may be performed by the sensor 131 and controller 132 of the battery diagnosis apparatus 130. According to one embodiment, the battery diagnosis method 900 may be implemented via execution of computing instructions configured to run at one or more processors.

In step 910, the battery diagnosis apparatus 130 may collect the plurality of resting voltages in the resting period after charging or discharging is terminated from the plurality of battery cells. In step 920, the battery diagnosis apparatus 130 may calculate the plurality of voltage deviations based on the difference between the representative value of the plurality of resting voltages and each resting voltage. Step 910 may further comprise calculating a plurality of second deviations based on a difference between a representative value of the plurality of voltage deviations and each of the plurality of voltage deviations.

In step 930, the battery diagnosis apparatus 130 may calculate the plurality of rates of change over time of the plurality of voltage deviations through the regression analysis. In step 940, the battery diagnosis apparatus 130 may diagnose the state of at least one or the plurality of battery cells based on the plurality of rates of change over time. Additionally and/or alternatively, in step 940 the battery diagnosis apparatus 130 may diagnose the state of at least one or the plurality of battery cells based on one or a plurality of the second deviations of the plurality of battery cells, either in addition to or without the plurality of rates of change of the plurality of voltage deviations. For example, according to one embodiment, the step 930 of calculating the plurality of rates of the voltage deviations may be skipped, and the plurality of second deviations may be calculated in step 920, which plurality of second deviations may be used in step 940 to diagnose at least one and even all of the plurality of battery cells.

According to one embodiment, battery management and/or diagnosing method can further comprise taking a further action is response to diagnosing of one or the plurality of battery cells, such as when a low voltage cell is identified, or when the cell is otherwise identified as abnormal. According to one embodiment, the controller may be configured to send a warning alarm to a user device and/or display terminal regarding the at least one diagnosed cell, such as for example a user device and/or display terminal registered with and/or associated with the diagnosed cell, so the user is alerted and can take action in response to the diagnosis. For example, the user may choose to stop or modify their use of the cell, or to repair or replace the cell, in response to the warning alarm. In another embodiment, the controller may be configured to open or cut power to the at least one diagnosed cell, to prevent damage or harm from the diagnosed cell. In another embodiment, the controller may be configured to electrically ground the at least one diagnosed cell, such as by shorting the cell to ground. According to another embodiment, the controller may be configured to limit or modify performance, output, and/or operating mode of an electrical device (e.g. consumer device, electric vehicle, etc.) using the at least one diagnosed cell. According to yet another embodiment, the controller may be configured to sending information regarding the at least one diagnosed cell to an external server, for example to enable the server to perform functions similar to those of (i)-(iv) to take action in response to the identification of a low voltage or otherwise abnormal cell.

According to an embodiment, the battery diagnosis method 900 may be implemented in the form of a computer program stored in a computer-readable storage medium. That is, the computer program may include instructions for implementing the battery diagnosis method 900, and the instructions of the program may be stored in the computer-readable storage medium. The computer program may include a mobile application.

According to an embodiment, the computer-readable storage media may include hardware devices, such as a magnetic media such as hard disks, floppy disks, and magnetic tapes, optical media such as CD-ROMs and DVDs, magneto-optical media such as floptical disks, a ROM, a RAM, and a memory flash, specifically configured to store and execute the computer program instructions. The computer program instructions may include machine codes created by a compiler and high-level language codes that can be executed by a computer using an interpreter. According to one embodiment, the controller comprises one or more processors, and one or more computer-readable media storing computing instructions that, when executed on the one or more processors, cause the one more processors to perform the steps and/or embodiments described herein.

Terms such as "include", "constitute", or "have" described above mean that the corresponding component can be contained unless specifically stated to the contrary, and thus should be interpreted as being able to include other components rather than excluding other components. All terms including technical or scientific terms, unless otherwise defined, have the same meaning as generally understood by a person of ordinary skill in the technical field to which the embodiments disclosed in this document pertain. Commonly used terms, such as those defined in dictionaries, should be interpreted consistent with the contextual meaning of the relevant technology and should not be interpreted in an idealized or overly formal sense unless explicitly defined in this document.

The above description is merely an illustrative description of the technical ideas disclosed in this document, and the person of ordinary skill in the technical field to which the embodiments disclosed in this document pertain will be able to make various modifications and variations thereto without departing from the essential characteristics of the embodiments disclosed in this document. Therefore, the embodiments disclosed in this document are not intended to limit the technical ideas of the embodiments disclosed in this document, but rather to explain them, and the scope of the technical ideas disclosed in this document is not limited by these embodiments. The scope of protection of the technical ideas disclosed in this document should be interpreted in accordance with the claims below, and all technical ideas within the scope equivalent to the claims below shall be interpreted as being included in the scope of rights of this document.

**Claims**

1. A battery management apparatus comprising:

a controller comprising one or more processors, and
one or more computer-readable media storing computing instructions that, when executed on the one or more processors, cause the one more processors to perform:

receiving a plurality of resting voltages for each of a plurality of battery cells, in a resting period after charging or discharging of the plurality of battery cells is completed,
calculating a plurality of voltage deviations for each of the plurality of battery cells based on a difference between a representative value of the plurality of resting voltages and each of the plurality of resting voltages for each of the plurality of battery cells,
calculating rates of change of the plurality of voltage deviations for each of the plurality of battery cells, and
diagnosing a state of at least one of the plurality of battery cell based on a rate of change over time of the at least one battery cell.

2. The apparatus of claim 1, wherein the computing instructions, when executed on the one or more processors, cause the one or more processors to perform:

calculating an average and a standard deviation of the rates of change of the plurality of battery cells, and
diagnosing whether or not a low voltage cell exists among the plurality of battery cells based on the average and the standard deviation.

3. The apparatus of claim 2, wherein the computing instructions, when executed on the one or more processors, cause the one or more processors to perform:

calculating a standard score for at least one of the plurality of battery cells based on the average and the standard deviation, and
diagnosing the at least one battery cell as the low voltage cell when the standard score of the at least one battery cell is lower than a lower limit threshold.

4. The apparatus of claim 1, wherein the computing instructions, when executed on the one or more processors, cause the one or more processors to perform:

calculating a plurality of second deviations based on a difference between a representative value of the plurality of voltage deviations and each of the plurality of voltage deviations, and
diagnosing whether or not a low voltage cell exists among the plurality of battery cells based on rates of change of the plurality of voltage deviations for each of the plurality of battery cells, and the plurality of second deviations.

5. The apparatus of claim 4, wherein the computing instructions, when executed on the one or more processors, cause the one or more processors to perform:

setting a normal range of the plurality of battery cells based on the plurality of second deviations and the plurality of rates of change over time, and
diagnosing a battery cell having a second deviation or rate of change outside the normal range as the low voltage cell.

6. The apparatus of claim 1, wherein the computing instructions, when executed on the one or more processors, cause the one or more processors to perform:

    calculating the plurality of voltage deviations for each of the plurality of battery cells based on a median of the plurality of resting voltages for each of the plurality of battery cells, and estimating slopes of each of the plurality of rates of change for each of the plurality of battery cells through a linear regression analysis.

7. The apparatus of claim 1, wherein the computing instructions, when executed on the one or more processors, cause the one or more processors to perform:

    receiving the plurality of resting voltages, wherein the plurality of resting voltages are collected during a first time section after a buffering time has elapsed from an end time point of charging of the plurality of battery cells, and/or wherein the plurality of resting voltages are collected during a second time section from an end time point of discharging of the plurality of battery cells.

8. The apparatus of claim 1, wherein the computing instructions, when executed on the one or more processors, cause the one or more processors to perform:
calculating rates of change of the plurality of voltage deviations for each of the plurality of battery cells through a regression analysis.

9. The apparatus of claim 1, wherein the computing instructions, when executed on the one or more processors, cause the one or more processors to perform:
diagnosing states of each of the plurality of battery cells based on rates of change over time of the plurality of battery cells.

10. The apparatus according to claim 1, further comprising a sensor configured to collect the plurality of resting voltages for each of the plurality of battery cells, in the resting period after charging or discharging of the plurality of battery cells is completed.

11. The apparatus according to claim 1, wherein the apparatus comprises an interface that is configured to communicate with a sensor to receive the plurality of resting voltages for each of the plurality of battery cells, wherein the sensor is configured to collect the plurality of resting voltages for each of the plurality of battery cells, in the resting period after charging or discharging of the plurality of battery cells is completed.

12. The apparatus of claim 1, wherein the computing instructions, when executed on the one or more processors, cause the one or more processors to perform:

    diagnosing at least one of the plurality of battery cells as a low-voltage cell and/or abnormal cell, and
in response to the diagnosis, performing any of i) sending a warning alarm to a user device and/or display terminal regarding the at least one diagnosed battery cell, ii) opening or cutting power to the at least one diagnosed battery cell, iii) electrically grounding the at least one diagnosed battery cell, iv) limiting or modifying performance, output, and/or operating mode of an electrical device using the at least one diagnosed battery cell, and v) sending information regarding the at least one diagnosed battery cell to an external server.

13. A battery management method implemented via execution of computing instructions configured to run at one or more processors, the method comprising:

    receiving a plurality of resting voltages collected for each of a plurality of battery cells, in a resting period after charging or discharging of the plurality of battery cells is completed;
calculating a plurality of voltage deviations for each of the plurality of battery cells based on a difference between a representative value of the plurality of resting voltages and each of the plurality of resting voltages for each of the plurality of battery cells;
calculating rates of change of the plurality of voltage deviations for each of the plurality of battery cells; and
diagnosing a state of at least one of the plurality of battery cells based on a rate of change of the at least one battery cell.

14. The method of claim 13, wherein the diagnosing of the state of the at least one of the plurality of battery cell comprises:

    calculating an average and a standard deviation of the rates of change of the plurality of battery cells; and
diagnosing whether or not a low voltage cell exists among the plurality of battery cells based on the average and the standard deviation.

15. The method of claim 14, wherein the diagnosing of the state of at least one of the plurality of battery cells comprises:

calculating a standard score for at least one of the plurality of battery cells based on the average and the standard deviation; and diagnosing the at least one battery cell as the low voltage cell when the standard score of the at least one battery cell is lower than a lower limit threshold.

16. The method of claim 13, wherein the diagnosing of the state of at least one of the plurality of battery cells comprises:

calculating a plurality of second deviations based on a difference between a representative value of the plurality of voltage deviations and each of the plurality of voltage deviations; and diagnosing whether or not a low voltage cell exists among the plurality of battery cells based on the rates of change of the plurality of voltage deviations for each of the plurality of battery cells, and the plurality of second deviations.

17. The method of claim 16, wherein the diagnosing of the state of at least one of the plurality of battery cells comprises:

setting a normal range of the plurality of battery cells based on the plurality of second deviations and the plurality of rates of change over time; and diagnosing a battery cell having a second deviation or rate of change outside the normal range as the low voltage cell.

18. The method of claim 13, wherein the calculating of the plurality of voltage deviations for each of the plurality of battery cells comprises:

calculating the plurality of voltage deviations based on a median of the plurality of resting voltages for each of the plurality of battery cells, and wherein the calculating of the plurality of rates of change of the plurality of voltage deviations comprises: estimating slopes of each of the plurality of rates of change for each of the plurality of battery cells through a linear regression analysis.

19. The method of claim 13, wherein the receiving of the plurality of resting voltages comprises:

receiving a plurality of resting voltages collected during a first time section after a buffering time has elapsed from an end time point of charging of the plurality of battery cells, and/or

receiving a plurality of resting voltages colected during a second time section from an end time point of discharging of the plurality of battery cells.

20. A battery management system comprising the battery management apparatus according to claim 1, the battery management system comprising:
a charger/discharger configured to charge or discharge a plurality of battery cells.

100

| CHARGER/<br>DISCHARGER<br>110 | ↔ | PLURALITY OF<br>BATTERY CELLS<br>120 | ↔ | BATTERY<br>DIAGNOSIS<br>APPARATUS<br>130 | ↔ | MANAGEMENT<br>SERVER<br>140 |

FIG.1

BATTERY DIAGNOSIS
APPARATUS
130

SENSOR
131

CONTROLLER
132

FIG.2

FIG.3

400

FIG.4

500

FIG.5

600

```
        ┌─────────────┐
        │    START    │
        └──────┬──────┘
               │
               ▼
   ┌──────────────────────────┐
   │   COLLECT VOLTAGES IN REST │────  610
   │   AFTER CHARGE/DISCHARGE   │
   └──────────┬───────────────┘
              │
              ▼
   ┌──────────────────────────┐
   │ CALCULATE DEVIATIONS FROM │────  620
   │          MEDIAN            │
   └──────────┬───────────────┘
              │
              ▼
   ┌──────────────────────────┐
   │   CALCULATE SLOPES USING   │────  630
   │  SIMPLE LINEAR REGRESSION  │
   └──────────┬───────────────┘
              │
              ▼
   ┌──────────────────────────┐
   │    CALCULATE STANDARD      │────  640
   │     SCORES OF SLOPES       │
   └──────────┬───────────────┘
              │
              ▼
```

650

STANDARD SCORE < -3

YES

NO

LOW VOLTAGE CELL ──── 670

NORMAL CELL ──── 660

END

FIG.6

700

FIG.7

FIG.8

900

```
                    ┌─────────────┐
                    │    START    │
                    └──────┬──────┘
                           │
                           ▼
        ┌──────────────────────────────────┐
        │  COLLECT PLURALITY OF RESTING     │
        │  VOLTAGES IN RESTING PERIOD AFTER │
        │  CHARGING OR DISCHARGING IS       │────910
        │  TERMINATED FROM PLURALITY        │
        │  OF BATTERY CELLS                 │
        └────────────────┬─────────────────┘
                         │
                         ▼
        ┌──────────────────────────────────┐
        │  CALCULATE PLURALITY OF VOLTAGE   │
        │  DEVIATIONS BASED ON DIFFERENCE   │
        │  BETWEEN REPRESENTATIVE VALUE OF  │────920
        │  PLURALITY OF RESTING VOLTAGES    │
        │  AND EACH RESTING VOLTAGE         │
        └────────────────┬─────────────────┘
                         │
                         ▼
        ┌──────────────────────────────────┐
        │  CALCULATE PLURALITY OF RATES OF  │
        │  CHANGE OVER TIME OF PLURALITY OF │────930
        │  VOLTAGE DEVIATIONS THROUGH       │
        │  REGRESSION ANALYSIS              │
        └────────────────┬─────────────────┘
                         │
                         ▼
        ┌──────────────────────────────────┐
        │  DIAGNOSE STATE OF PLURALITY OF   │
        │  BATTERY CELLS BASED ON PLURALITY │────940
        │  OF RATES OF CHANGE OVER TIME     │
        └────────────────┬─────────────────┘
                         │
                         ▼
                    ┌─────────────┐
                    │     END     │
                    └─────────────┘
```

FIG.9

## INTERNATIONAL SEARCH REPORT

| International application No. |
|---|
| **PCT/KR2024/015736** |

| A. | CLASSIFICATION OF SUBJECT MATTER |
|---|---|

**G01R 31/392**(2019.01)i; **G01R 31/396**(2019.01)i; **G01R 31/385**(2019.01)i; **G01R 31/382**(2019.01)i; **G01R 19/10**(2006.01)i; **G01R 19/12**(2006.01)i; **G01R 19/00**(2006.01)i; **G01R 19/165**(2006.01)i; **G01R 31/367**(2019.01)i; **G06F 17/18**(2006.01)i

According to International Patent Classification (IPC) or to both national classification and IPC

| B. | FIELDS SEARCHED |
|---|---|

Minimum documentation searched (classification system followed by classification symbols)

G01R 31/392(2019.01); G01R 31/36(2006.01); G01R 31/382(2019.01); G01R 31/50(2020.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 휴지 기간(rest period), 휴지 전압(rest voltage), 대표값(representative value), 편차 (deviation), 배터리 관리 장치(battery management device)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2021-0059566 A (SAMSUNG SDI CO., LTD.) 25 May 2021 (2021-05-25)<br>See paragraphs [0011]-[0063]. | 1,4-5,7,9-13,<br>16-17,19-20 |
| A | | 2-3,6,8,14-15,18 |
| Y | KR 10-2021-0074003 A (LG ENERGY SOLUTION, LTD.) 21 June 2021 (2021-06-21)<br>See claim 1. | 1,4-5,7,9-13,<br>16-17,19-20 |
| A | KR 10-2022-0146255 A (LG ENERGY SOLUTION, LTD.) 01 November 2022 (2022-11-01)<br>See paragraphs [0035]-[0073] and claim 1. | 1-20 |
| A | KR 10-2022-0012747 A (LG ENERGY SOLUTION, LTD.) 04 February 2022 (2022-02-04)<br>See claim 1 and figures 3-9b. | 1-20 |

| ✓ | Further documents are listed in the continuation of Box C. | ✓ | See patent family annex. |
|---|---|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **24 January 2025** | **24 January 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2024/015736**

**C.    DOCUMENTS CONSIDERED TO BE RELEVANT**

| Category* | Citation of document, with indication, where appropriate, of the relevant passages | Relevant to claim No. |
|---|---|---|
| A | KR 10-2022-0169433 A (LG CHEM, LTD.) 27 December 2022 (2022-12-27)<br>See claim 1. | 1-20 |

Form PCT/ISA/210 (second sheet) (July 2022)

**INTERNATIONAL SEARCH REPORT**
Information on patent family members

| International application No. |
| --- |
| **PCT/KR2024/015736** |

| Patent document cited in search report | | | Publication date (day/month/year) | Patent family member(s) | | | Publication date (day/month/year) |
| --- | --- | --- | --- | --- | --- | --- | --- |
| KR | 10-2021-0059566 | A | 25 May 2021 | KR | 10-2362208 | B1 | 10 February 2022 |
| KR | 10-2021-0074003 | A | 21 June 2021 | CN | 114207456 | A | 18 March 2022 |
| | | | | CN | 114207456 | B | 12 April 2024 |
| | | | | EP | 3989330 | A1 | 27 April 2022 |
| | | | | EP | 3989330 | A4 | 31 August 2022 |
| | | | | EP | 3989330 | B1 | 20 September 2023 |
| | | | | ES | 2960033 | T3 | 29 February 2024 |
| | | | | HU | E062992 | T2 | 28 December 2023 |
| | | | | JP | 2022-536310 | A | 15 August 2022 |
| | | | | JP | 7293566 | B2 | 20 June 2023 |
| | | | | PL | 3989330 | T3 | 22 January 2024 |
| | | | | US | 11821960 | B2 | 21 November 2023 |
| | | | | US | 2022-0373607 | A1 | 24 November 2022 |
| | | | | WO | 2021-118118 | A1 | 17 June 2021 |
| KR | 10-2022-0146255 | A | 01 November 2022 | | None | | |
| KR | 10-2022-0012747 | A | 04 February 2022 | CN | 115667961 | A | 31 January 2023 |
| | | | | EP | 4137829 | A1 | 22 February 2023 |
| | | | | EP | 4137829 | A4 | 08 November 2023 |
| | | | | JP | 2023-526935 | A | 26 June 2023 |
| | | | | JP | 7416982 | B2 | 17 January 2024 |
| | | | | KR | 10-2717609 | B1 | 16 October 2024 |
| | | | | US | 2023-0184838 | A1 | 15 June 2023 |
| | | | | WO | 2022-019703 | A1 | 27 January 2022 |
| KR | 10-2022-0169433 | A | 27 December 2022 | CN | 117795355 | A | 29 March 2024 |
| | | | | EP | 4300109 | A1 | 03 January 2024 |
| | | | | EP | 4300109 | A4 | 04 September 2024 |
| | | | | JP | 2024-509525 | A | 04 March 2024 |
| | | | | JP | 7550322 | B2 | 12 September 2024 |
| | | | | US | 2024-0168093 | A1 | 23 May 2024 |
| | | | | WO | 2022-265458 | A1 | 22 December 2022 |
| | | | | WO | 2022-265458 | A8 | 16 November 2023 |

Form PCT/ISA/210 (patent family annex) (July 2022)

**REFERENCES CITED IN THE DESCRIPTION**

**Patent documents cited in the description**

- KR 1020230139022
- KR 1020240141241